# EUROPÄISCHE PATENTSCHRIFT

(11) **EP 0 922 377 B1**
(45) Veröffentlichungstag und Bekanntmachung des Hinweises auf die Patenterteilung: **11.10.2000**
(21) Anmeldenummer: 97935483.4
(22) Anmeldetag: 25.07.1997
(51) Int. Cl.: H05K 5/00, G01P 1/02

(54) **GEHÄUSE FÜR EIN ELEKTRISCHES STEUERGERÄT MIT FALLEMPFINDLICHEN BAUELEMENTEN, INSBESONDERE SENSOR(EN) ZUM AUSLÖSEN VON SCHUTZVORRICHTUNGEN IN KRAFTFAHRZEUGEN**
ELECTRIC ACTUATOR CASING COMPRISING FALL SENSITIVE ELEMENTS, ESPECIALLY ONE OR MORE SENSORS INTENDED FOR TRIGGERING PROTECTIVE DEVICES INSIDE VEHICULES
BOITIER DE COMMANDE ELECTRIQUE COMPRENANT DES ELEMENTS SENSIBLES A LA CHUTE, NOTAMMENT UN OU DES CAPTEURS DE DECLENCHEMENT DE DISPOSITIFS DE PROTECTION A L'INTERIEUR DE VEHICULES

(30) Priorität: 29.08.1996 DE 19634961
(43) Veröffentlichungstag der Anmeldung: 16.06.1999
(73) Patentinhaber: ROBERT BOSCH GMBH, 70442 Stuttgart (DE)
(72) Erfinder: JAKOB, Gert, D-70378 Stuttgart (DE); LIEGL, Erwin, D-71735 Eberdingen (DE); BUSS, Heiko, El Paso, TX 7990 (US)
(86) Internationale Anmeldenummer: DE9701571
(87) Internationale Veröffentlichungsnummer: WO9809488

(56) Entgegenhaltungen:
- WO-A-93/05399
- DE-A- 4 242 943
- DE-A- 4 243 180

## Beschreibung

Die Erfindung geht aus von einem Gehäuse für ein elektrisches Steuergerät mit fallempfindlichen Bauelementen, insbesondere Sensor(en) zum Auslösen von Schutzvorrichtungen in Kraftfahrzeugen, nach der Gattung des unabhängigen Anspruchs 1. Aus der WO 93/05399 ist ein fallempfindlicher Sensor bekannt, der zum Schutz vor Beschädigungen, insbesondere durch Herabfallen des Sensors vor der eigentlichen Montage in eine zusätzliche, formschlüssig mit dem Gehäuse des Sensors verbundene Verpackung aus elastischem, Stöße kompensierendem Material eingepackt ist. Diese zusätzliche Verpackung weist mehrere Fortsätze aus elastischem Material auf. Falls der Sensor auf den Boden fallen würde, ist er zwar durch die dämpfenden Eigenschaften der Verpackung geschützt, diese Verpackung ist aber zusätzlich angebracht und vergrößert dadurch die Bauform des Sensors. Dadurch baut der Sensor sehr sperrig und ist nur bei großem Bauraum verwendbar. Die zusätzliche Verpackung ist mit zusätzlichen Kosten verbunden.

### Vorteile der Erfindung

Das erfindungsgemäße Gehäuse mit den Merkmalen des unabhängigen Anspruchs 1 hat demgegenüber den Vorteil, daß bei nur äußerst geringen oder keinen Mehrkosten und Fertigungsaufwand der Sensor vor Beschädigungen, zum Beispiel durch Herabfallen vor dem Einbau, geschützt werden kann. Die auf den Sensor bzw. auf das Gehäuse bei einem Herabfallen einwirkende Energie kann in einfacher Weise durch die Fortsätze, die aus dem gleichen Material wie das eigentliche Gehäuse bestehen, kompensiert werden. Da die Fortsätze aus dem gleichen Material wie das Gehäuse bestehen, können das Gehäuse und die Fortsätze in einem einzigen Arbeitsgang hergestellt werden. Da bei herkömmlichen Sensoren das Gehäuse meistens aus sprödem Werkstoff, insbesondere Druckguß, besteht und deren Verwendung zulässig ist, ist die Herstellung besonders einfach. Die plastische Verformung oder der Bruch der Zapfen bzw. der Fortsätze kann auch als Indikator verwendet werden, der anzeigt, daß der Sensor bereits einmal auf den Boden gefallen ist und dabei eine bestimmte vorgesehene Energieschwelle überschritten hat. Bei der Verwendung von Aluminiumdruckguß für das Gehäuse können die Fortsätze nahezu ohne Mehrkosten im Gußvorgang mit angebracht werden.

Durch die in den Unteransprüchen aufgeführten Maßnahmen sind vorteilhafte Weiterbildungen des im Anspruch 1 angegebenen Gehäuses möglich.

### Zeichnung

Ein Ausführungsbeispiel der Erfindung ist in der Zeichnung dargestellt und in der nachfolgenden Beschreibung näher erläutert. Die einzige Figur zeigt eine perspektivische Darstellung eines Gehäuses.

### Beschreibung des Ausführungsbeispiels

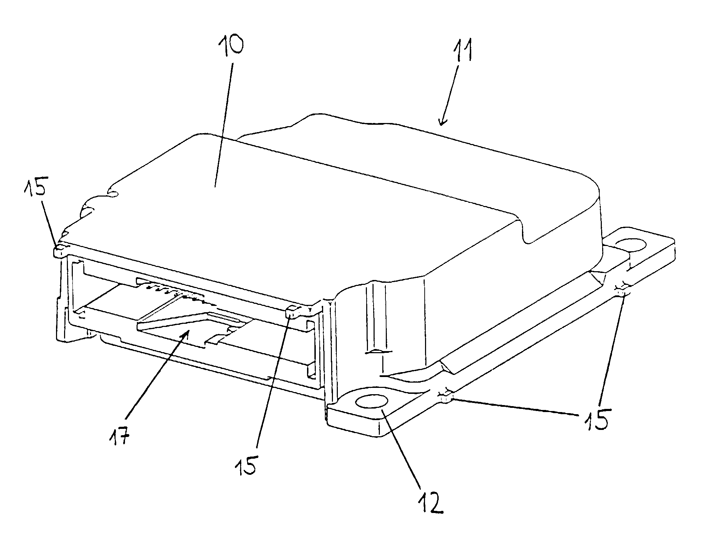

In der Figur 1 ist mit 10 das Gehäuse eines Sensors 11 zum Auslösen von Schutzvorrichtungen, wie zum Beispiel Gurtstraffer, Airbag, Warnblinkanlagen oder Überrollbügel in Kraftfahrzeugen bezeichnet. Es sind aber auch sonstige fallempfindliche Sensoren, wie zum Beispiel ABS (Anti-Blockier-System) und ASR (Antriebs-Schlupf-Regelung) anwendbar. Als Sensor kann jeder nach verschiedenen Meßprinzipien arbeitende und in der Praxis erhältliche Sensor verwendet werden. Statt eines Sensors kann das Gehäuse 10 auch ein Steuergerät mit elektronischen Bauteilen zur Steuerung eines Antiblockier-Systems oder einer Antriebsschlupfregelung aufweisen. Am Gehäuse 10 sind mehrere flanschartige Laschen 12 angeordnet, mit denen das Gehäuse zum Beispiel in einem Kraftfahrzeug befestigt werden kann. Ferner sind an verschiedenen Stellen des Gehäuses mehrere Fortsätze 15 ausgebildet, insbesondere befinden sie sich auf der Seite bzw. den Seiten, wo die höchsten Beschleunigungen beim Fallen auftreten. Diese Fortsätze bestehen aus dem selben Material wie das Gehäuse 10 selbst, also zum Beispiel aus Aluminiumdruckguß. Ferner sind grundsätzlich spröde Werkstoffe zulässig, die eine plastische Verformung der Fortsätze 15 bewirken. Die Form dieser Fortsätze 15 wird primär durch die Herstellungsweise des Gehäuses 10 bestimmt. Die Fortsätze 15 können zum Beispiel, wie in der Figur, einen rechteckigen oder quadratischen Querschnitt aufweisen. Besonders bevorzugt sind die Fortsätze 15 im Bereich der Öffnung des Steckers 17 angeordnet, um somit die Steckerkontakte zu schützen bzw. zu überwachen. Ferner befinden sie sich im Bereich zwischen den Laschen 12. Es ist darauf zu achten, daß die Fortsätze 15 relativ kurz ausgebildet sind. Bei langen Fortsätzen würden diese die Handhabung des Gehäuses 10 behindern und eventuell zu Verletzungen führen. Kurze Zapfen reichen aus, um die bei einem Aufprall des Gehäuses vor dem Einbau auftretende Fallenergie zu kompensieren. Die Fortsätze 15 sind dabei so auszubilden, insbesondere von der Auswahl des Materials her abzustimmen, daß unterhalb einer gewünschten Energiegrenze diese Aufprallenergie kompensiert wird, ohne daß die fallempfindlichen Bauelemente, insbesondere Sensor(en) geschädigt werden. In besonderen Fällen, abhängig von der Spezifikation, reicht es aus, wenn eine optisch erkennbare plastische Verformung oder ein Bruch des Zapfens eintritt, wenn eine vorgesehene Energieschwelle überschritten wird. Dadurch ist ein einfach erkennbarer optischer Indikator vorhanden, an dem erkannt werden kann, ob das Gerät eventuell schon auf den Boden gefallen ist und eine Beschädigung der elektronischen Bauteile aufweisen könnte.

## Patentansprüche

1. Gehäuse (10) für ein elektrisches Steuergerät mit fallempfindlichen Bauelementen, insbesondere Sensor(en), zum Auslösen von Schutzvorrichtungen in Kraftfahrzeugen, mit mindestens einem angeformten Fortsatz (15), wobei das Gehäuse (10) und der oder die Fortsätze (15) aus dem gleichen, zumindest plastisch verformbaren Material bestehen.

2. Gehäuse nach Anspruch 1, dadurch gekennzeichnet, daß das Gehäuse (10) und die Fortsätze (15) ein einteiliges Bauteil bilden.

3. Gehäuse nach Anspruch 1 und/oder 2, dadurch gekennzeichnet, daß das Material Druckguß ist.

4. Gehäuse nach einem der Ansprüche 1 bis 3, dadurch gekennzeichnet, daß die Fortsätze (15) wenigstens im Bereich einer Öffnung für einen Stecker (17) angeordnet sind.

5. Gehäuse nach einem der Ansprüche 1 bis 4, dadurch gekennzeichnet, daß die Fortsätze (15) wenigstens im Bereich zwischen Befestigungslaschen (12) angeordnet sind.

## Claims

1. Casing (10) for an electric control unit having fall-sensitive elements, in particular sensor/sensors, for triggering protection devices in motor vehicles, having at least one integrally formed-on projection (15), the casing (10) and the projection or the projections (15) being composed of the same, at least plastically deformable material.

2. Casing according to Claim 1, characterized in that the casing (10) and the projections (15) form a single-piece component.

3. Casing according to Claim 1 and/or 2, characterized in that the material is a diecast moulding.

4. Casing according to one of Claims 1 to 3, characterized in that the projections (15) are arranged at least in the vicinity of an opening for a plug (17).

5. Casing according to one of Claims 1 to 4, characterized in that the projections (15) are arranged at least in the region between attachment clips (12).

## Revendications

1. Boîtier de commande électrique (10) comprenant des éléments sensibles à la chute, notamment un ou des capteurs de déclenchement de dispositifs de protection à l'intérieur des véhicules, avec au moins un ergot (15), le boîtier (10) et le ou les ergots (15) étant constitués du même matériau, déformable au moins plastiquement.

2. Boîtier suivant la revendication 1,
caractérisé en ce que
le boîtier (10) et les ergots (15) sont formés d'une seule pièce.

3. Boîtier suivant la revendication 1 et/ou 2,
caractérisé en ce que
le matériau est coulé sous pression.

4. Boîtier suivant les revendications 1 à 3,
caractérisé en ce que
les ergots (15) sont disposés, au moins dans la zone d'une ouverture pour une prise de courant (17).

5. Boîtier suivant les revendications 1 à 4,
caractérisé en ce que
des ergots (15) sont disposés au moins dans la zone située entre les oeillets de fixation (12).
